# FASCICULE DE BREVET EUROPEEN

(11) **EP 2 856 530 B1**
(45) Date de publication et mention de la délivrance du brevet: **27.07.2016**
(21) Numéro de dépôt: 13739797.2
(22) Date de dépôt: 03.06.2013
(51) Int. Cl.: H01L 51/10, H01L 51/44, H01L 51/00

(54) **PROCÉDÉ DE RÉALISATION D'UN EMPILEMENT DU TYPE PREMIÈRE ÉLECTRODE/COUCHE ACTIVE/DEUXIÈME ÉLECTRODE**
VERFAHREN ZUR HERSTELLUNG EINES STAPELS AUS EINER ERSTEN ELEKTRODE/EINER AKTIVEN SCHICHT/EINER ZWEITEN ELEKTRODE
METHOD FOR PRODUCING A FIRST ELECTRODE/ACTIVE LAYER/SECOND ELECTRODE STACK

(30) Priorité: 05.06.2012 FR 1255222
(43) Date de publication de la demande: 08.04.2015
(73) Titulaire: Commissariat à l'Énergie Atomique et aux Énergies Alternatives, 75015 Paris (FR); ISORG, 38040 Grenoble Cedex 09 (FR)
(72) Inventeur: VERILHAC, Jean-Marie, F-38500 Coublevie (FR); CHARLOT, Simon, F-38100 Grenoble (FR)
(74) Mandataire: Gevers & Orès
(86) Numéro de dépôt international: PCT/IB2013/054563
(87) Numéro de publication internationale: WO 2013/182970

(56) Documents cités:
- JP-A- 11 307 251
- US-A- 5 350 459
- US-A1- 2002 167 272
- US-A1- 2004 099 305
- US-A1- 2006 186 400

## Description

L'invention concerne les empilements de type conducteur/couche mince organique/conducteur, classiquement utilisés dans des dispositifs électroniques.

Ces dispositifs peuvent par exemple être des diodes redresseuses de courant, des cellules solaires, des cellules photodétectrices, des capacités, des diodes laser, des dispositifs types capteurs, des mémoires, ou encore des diodes électroluminescentes. Il s'agit notamment de dispositifs de l'électronique organique sur substrat plastique souple.

L'invention s'applique plus particulièrement au domaine des empilements de diodes utilisés dans les cellules solaires organiques ou les photodétecteurs organiques.

Dans les dispositifs connus dans l'état de la technique, on peut constater l'apparition de courants de fuite électrique à travers la couche mince organique qui est censée isoler électriquement les deux électrodes conductrices, également appelée couche active.

Ces courants de fuite dépendent d'une part, des propriétés intrinsèques de la couche active, notamment sa conductivité, de la présence de pièges électriques, du positionnement des niveaux énergétiques HOMO-LUMO par rapport aux travaux de sortie des électrodes, ou de sa morphologie, et d'autre part, de paramètres extrinsèques comme les courants de fuite électrique parasites.

Ces courants parasites ne sont pas maîtrisés. Ils proviennent essentiellement de défauts topologiques, c'est-à-dire des trous ou des défauts morphologiques, c'est-à-dire des zones de volume libre plus important. Ils sont générés lors de la formation de la couche active.

Ainsi, la présence de trous dans la couche active peut conduire à court-circuiter localement les deux électrodes conductrices. Par ailleurs, les zones de morphologie différente sont plus propices au claquage électrique.

Ces défauts dans la couche active peuvent être dus aux matériaux utilisés pour former la couche, lesquels sont sous forme d'une solution pouvant comporter des agrégats, c'est-à-dire des parties du matériau mal dissoutes dans la solution. Ils peuvent également résulter de défauts présents sur le substrat, tels que des pics ou défauts topologiques de la surface ou des zones présentant des tensions de surface différentes.

Ces courants de fuite parasites sont très pénalisants lorsqu'ils surviennent dans des photodétecteurs organiques ou des diodes redresseuses de courant.

En effet, dans ce cas, le courant en régime inverse de la diode et dans le noir doit être très faible (de l'ordre du nA/cm²). Ainsi, la moindre fuite électrique à travers les défauts de la couche active peut faire augmenter ce courant de plusieurs décades et dégrader les performances de la diode de manière drastique et irréversible.

Ces courants de fuite parasites sont également pénalisants pour les cellules solaires organiques, mais dans une moindre mesure.

Pour un tel dispositif, plus le courant de fuite de la diode est faible et plus la cellule solaire pourra répondre à une faible illumination.

Ainsi, il a déjà été proposé des solutions pour minimiser les courants de fuite parasites dans la couche active d'un empilement.

Il a notamment été proposé d'augmenter l'épaisseur de la couche active, de filtrer les solutions avant leur dépôt pour former la couche active et d'utiliser des substrats présentant peu de défauts.

Cependant, les solutions proposées présentent des inconvénients.

En effet, une trop forte augmentation de l'épaisseur de la couche active tend par exemple à dégrader les performances des dispositifs. C'est pourquoi l'épaisseur de la couche active est généralement de l'ordre de 200-300 nm. Par ailleurs, une filtration nécessite une solution présentant une bonne solubilité ce qui n'est pas le cas de tous les matériaux actuellement disponibles pour les couches actives. De plus, l'étape de filtration est difficile à mettre en oeuvre au niveau industriel. Enfin, les substrats présentant peu de défauts sont des substrats avec des couches planarisantes qui sont d'un coût élevé.

L'invention a pour objet de minimiser les courants de fuite électriques parasites à travers la couche active d'un empilement du type conducteur/couche active/conducteur, tout en maintenant les performances des dispositifs correspondants.

Ainsi, l'invention a pour objet un procédé de réalisation d'un empilement du type première électrode/couche active/deuxième électrode selon la revendication 1 destiné à un dispositif électronique notamment du type photodétecteur organique ou cellule solaire organique, comportant les étapes suivantes :
(a) dépôt d'une première couche de matériau conducteur sur un substrat, pour former la première électrode,
(b) dépôt d'une couche active, sous la forme d'une couche mince semi-conductrice organique, cette couche comportant des zones non continues,
(c) élimination locale par attaque chimique de la première couche conductrice, à travers les zones non continues de la couche active et
(d) dépôt d'une deuxième couche de matériau conducteur sur la couche active, pour former la deuxième électrode conductrice.

Du fait de l'élimination locale de la couche conductrice, au niveau des défauts de la couche active, les deux électrodes ne peuvent plus être en contact et de ce fait, ne peuvent pas créer de court-circuit électrique à travers la couche active. Les courants de fuite électriques sont donc considérablement réduits.

La première couche de matériau conducteur peut être réalisée en au moins un matériau pris parmi un oxyde conducteur transparent, un métal et un matériau carboné.

Le métal peut se présenter sous forme d'une couche continue ou sous la forme d'un réseau de nanofils métalliques.

De façon préférée, l'étape (c) est réalisée au moyen d'une solution de gravure ou d'un solvant.

Cette solution de gravure, comme le solvant, peut être appliquée sur l'ensemble de la couche active ou de façon localisée.

Par ailleurs, la couche active peut être déposée sur la première couche de matériau conducteur sous la forme d'une couche continue ou de façon localisée.

De façon préférée, une couche d'interface peut être déposée entre la première couche de matériau conducteur et la couche active, c'est-à-dire entre les étapes (a) et (b). De même, une couche d'interface peut être déposée entre la couche active et la deuxième couche conductrice, c'est-à-dire entre les étapes (c) et (d).

Il convient de noter que cette couche d'interface ne serait pas suffisante pour assurer l'isolation électrique entre les deux électrodes conductrices au niveau des défauts de la couche active, si le procédé selon l'invention n'était pas mis en oeuvre.

Par ailleurs, une couche de matériau diélectrique est avantageusement déposée localement entre la première couche de matériau conducteur et la couche active ou sur cette dernière.

Enfin, l'invention concerne un empilement du type première électrode/couche active/deuxième électrode, destiné à un dispositif électronique et comprenant successivement selon la revendication 10 :
- une première couche de matériau conducteur formant la première électrode et comportant des zones dépourvues de tout matériau,
- une couche active, sous la forme d'une couche mince semi-conductrice organique, cette couche comportant des zones non continues, et
- une deuxième couche de matériau conducteur, formant la deuxième électrode conductrice.
, les zones dépourvues de tout matériau situées au-dessous des zones non continués de la couche active et les zone dépourvues de tout matériau ayant au moins des dimensions des zones non continues.
L'invention sera mieux comprise et d'autres buts, avantages et caractéristiques de celle-ci apparaîtront plus clairement à la lecture de la description qui suit et qui est faite au regard des dessins annexés, sur lesquels :
- les figures 1 à 3 représentent des étapes de mise en oeuvre du procédé selon l'invention, toutes ces figures sont des vues en coupe,
- la figure 4 est une vue de dessus d'un détail de la figure 2, et
- la figure 5 est un graphe indiquant, pour des diodes selon l'état de l'art (■) et pour des diodes obtenues par un procédé selon l'invention (●), le courant de fuite mesuré.

Les éléments communs aux différentes figures seront désignés par les mêmes références.

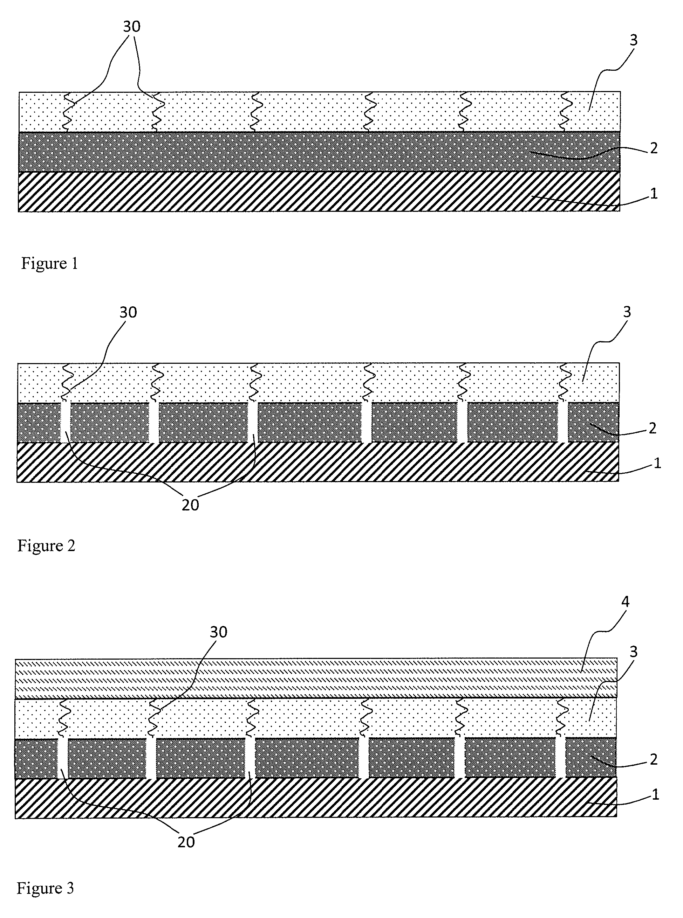

La figure 1 illustre un substrat 1 qui peut être de nature quelconque. Il s'agit par exemple d'un substrat rigide en verre ou d'un substrat flexible en matière plastique, par exemple du type PET ou PEN.

Sur le substrat 1, a été déposée une couche 2 d'un matériau conducteur. Cette couche 2 formera la première électrode conductrice.

Cette première électrode est, de préférence, semi-transparente pour des longueurs d'onde dans le domaine UV-visible-proche IR.

L'épaisseur de la couche 2 est comprise entre 1 nm et plusieurs micromètres.

Le matériau constitutif de la couche 2 peut être de l'un des quatre types qui vont être décrits.

Il peut tout d'abord s'agir d'un oxyde conducteur transparent (type 1).

Cet oxyde peut être déposé sous la forme d'une couche unique, par exemple en oxyde d'indium - étain (ITO), en ZnO dopé Al (AZO), ZnO dopé au Gallium (GZO), ZnO dopé Indium (IZO), ZnO dopé Indium et Gallium (IGZO).

Cet oxyde peut également être déposé sous la forme de deux ou trois couches de matériaux différents, par exemple ITO/Ag/ITO, AZO/Ag/AZO, AZO/Au/AZO, AZO/Ag/ZnO, ou encore ZnO/Ag/ZnO.

Le matériau de la couche 2 peut également être un métal (type 2), par exemple Ag, Au, Pd, Pt, Cu, Cr, Ti, Al, TiW ou Ni.

La couche métallique peut être une couche massive ou une couche à base de nanoparticules (Ag, Au...). Dans les deux cas, la couche est continue.

Cette couche métallique présentera une épaisseur faible, notamment inférieure à 10 nm, si la première électrode doit être transparente. Dans le cas inverse, l'épaisseur pourra être plus importante.

La couche conductrice peut également être réalisée sous la forme d'un tapis ou d'un réseau de nanofils métalliques percolants (type 3). Ainsi, une continuité électrique existe entre les nanofils du réseau. Dans ce cas, la couche est non continue. Elle peut être prévue sur toute la surface du substrat ou localisée spatialement.

Ces nanofils peuvent notamment être réalisés en argent ou en or.

Enfin, la couche 2 peut être réalisée avec des matériaux carbonés (type 4).

Il peut notamment s'agir de polymères conducteurs, du type PEDOT/PSS, polyaniline (PANI), de réseaux de nanotubes de carbone conducteurs percolants, ou encore de graphène.

Pour tous les types de conducteur, la couche 2 pourra être une couche continue ou localisée spatialement. Dans les deux cas, elle pourra être soit non structurée (couche continue ou sous forme de tapis de nanofils), soit structurée, par exemple sous forme de grille.

En pratique, la couche 2 pourra être constituée exclusivement d'un matériau d'un des quatre types mentionnés plus haut. Elle pourra également se présenter sous la forme d'un mélange à base de plusieurs de ces matériaux ou encore d'un empilement de couches de ces différents matériaux, seuls ou en mélange. Un exemple de mélange pourrait être une couche de type 4 réalisée en PEDOT/PSS dopé aux nanotubes de carbone ou encore un matériau de type 4 mélangé avec un matériau des types 1, 2 ou 3.

La couche 2 peut être déposée par des techniques classiques sous vide, par exemple par évaporation ou pulvérisation cathodique. Elle peut également être déposée par voie liquide par exemple par une technique d'impression de type sérigraphie, sous forme atomique ou sous forme de dispersion de particules. Ces particules peuvent être de taille nanométrique ou microscopique ou encore être du type nanofilamentaire. Enfin, la couche 2 peut également être déposée sous la forme de sol-gels.

De façon optionnelle, une couche d'interface peut être déposée sur la couche 2. Cette couche n'est pas représentée sur la figure 1.

Cette couche d'interface peut par exemple être réalisée en PEDOT/PSS, graphène, dérivé de polyfluorene, tetrakis (dimethylamino)éthylène (TDAE), poly(oxyde d'éthylène), polyethylenimine ethoxylé (PEIE), polyethylenimine branché (PEI), WO3, MoO3, LiF, NiO, V2O5, TiOx, ZnO ou CsCO3 ou encore par l'utilisation d'une couche auto-assemblée (SAM) à la surface de l'électrode conductrice.

Cette couche d'interface permet d'ajuster le travail de sortie de la première électrode conductrice 2 par rapport à la couche active 3. Par exemple si l'ITO a un travail de sortie de 4.6eV, l'utilisation d'une fine couche de ZnO à sa surface permet d'ajuster le travail de sortie de surface (à l'interface électrode/couche active) à 4.3eV sans trop modifier la conductivité de l'électrode conductrice perpendiculairement au substrat.

Sur la couche 2 ou, éventuellement, sur la couche d'interface déposée sur la couche 2, est déposée une couche active 3.

L'épaisseur de cette couche 3 est par exemple comprise entre 1 nm et plusieurs micromètres.

Dans le cas des photodétecteurs organiques et des cellules solaires organiques, la couche active est constituée d'au moins un matériau qui est de nature semi-conducteur.

Elle est avantageusement constituée d'un mélange d'un matériau donneur d'électrons et d'un matériau accepteur d'électrons. Le matériau semi-conducteur donneur peut être une molécule, un oligomère ou un polymère organique π conjugué, c'est-à-dire avec une alternance de liaisons simples et de liaisons double. Le mélange classiquement utilisé est le couple poly(3-hexylthiophène) régiorégulier (P3HT RR) et le [6,6]-Phényl C61 butyric acid methyl ester ([60]PCBM). D'autres polymères donneurs à fort gap (PFB, TFB, PTAA, PCDTBT, etc...) ou à faible gap (PDPP3T, PCPDTBT, Si-PCPDTBT, PDDTT, etc...) pourront avantageusement être utilisés. De même, pour le matériau accepteur, d'autres matériaux peuvent avantageusement être utilisés, du type dérivés du C60, C70 ou C80 (PCBM, indène-C60, indene-C60 bis adduct), nanotubes de carbone, molécules de type acène diimide, ou polymère (F8BT, N2200). Dans le cas où on se réfère aux exemples 4 et 5 mentionnés ci-après, le matériau accepteur peut également être de nature inorganique, comme des nanoparticules de TiO2 ou de ZnO.

Ainsi, la couche active peut être une hétérojonction d'un matériau donneur d'électrons et d'un matériau accepteur d'électrons se présentant sous la forme d'une couche ou d'un empilement de plusieurs couches. Il peut également s'agir d'un mélange à l'échelle nanométrique des deux matériaux sous la forme d'hétérojonction en volume, c'est-à-dire d'un mélange intime des deux matériaux à l'échelle nanométrique.

Les matériaux constitutifs de la couche active sont déposés sous la forme de solutions. Ces solutions peuvent être filtrées de façon à limiter la présence d'agrégats. Ceci permet également de limiter la création de défauts dans la couche active.

Comme indiqué précédemment, la couche active 3 comporte des zones non continues, ou encore des défauts, référencés 30 sur la figure 1.

Ces défauts peuvent consister en des trous micrométriques ou en des zones présentant des volumes libres importants. Il peut s'agir de porosité ou encore de volumes qui ne sont pas occupés par les chaines polymères. Ils présentent des dimensions comprises entre 1 nm et plusieurs millimètres.

La figure 2 illustre une autre étape du procédé au cours de laquelle la couche conductrice est éliminée localement à travers les défauts 30.

Cette élimination locale sera obtenue par une technique de gravure de préférence en voie humide, c'est-à-dire par mise en contact avec une solution de gravure. Dans certains cas, cette élimination est obtenue avec un solvant. C'est cependant le terme de solution de gravure qui sera généralement utilisé dans la suite de la description.

Bien entendu, la solution de gravure doit être choisie de façon à ne pas dégrader les propriétés électriques, optiques et mécaniques de la couche active. Les propriétés électriques de la couche active peuvent être dégradées du fait d'une augmentation ou d'une diminution de sa conductivité, ou encore de la génération de pièges électriques intrinsèques ou extrinsèques à la couche active. La dégradation des propriétés optiques de la couche active peut par exemple se traduire par une diminution des propriétés d'absorption de la lumière à la longueur d'onde désirée. Enfin, la dégradation des propriétés mécaniques peut se traduire notamment par un décollement, une fissuration ou une perte de flexibilité de la couche active.

Ainsi, de façon générale, la solution de gravure utilisée sera sélective, c'est-à-dire qu'elle pourra graver la couche conductrice 2, sans pour autant graver ou attaquer la couche active 3.

De façon générale, la solution de gravure comprendra un acide, une base ou une solution neutre. Elle pourra être pure ou encore diluée dans l'eau ou dans un solvant orthogonal à la couche active, c'est-à-dire un solvant non susceptible d'attaquer ou de dissoudre la couche active. Un solvant orthogonal peut être du type méthanol, éthanol, éthylène glycol, di-éthylène glycol, PGMEA, 3-methoxypropionitrile, 2-ethoxyethanol, 1,2 dichloroethane, 1-butanol, n-butylacetate ou encore isopropanol.

De façon préférée, la solution de gravure sera diluée dans l'eau et, de préférence, dans de l'eau désionisée pour éviter la contamination éventuelle par des ions, notamment métalliques (Na+, etc...).

L'homme du métier sait choisir la nature et la concentration de l'acide fort (du type HNO₃, HCl, H₂SO₄, Kl, acide oxalique ou encore H₃PO₄) ou faible (du type acide oxalique, CH₃CO₂H ou NH₄+), ou encore de la base forte (du type NaOH ou KOH) ou faible (du type NH₃ ou CH₃CO₂-), en fonction de la nature de l'électrode conductrice et de la vitesse de gravure. Il est notamment fait référence, à cet égard, à l'ouvrage « Thin Film Processes » édité par John L. Vossen and Werner Kern, Academic Press, New York, 1978.

De façon générale, la vitesse de gravure est comprise entre 1 et 1 000 Å/s.

La solution de gravure est apportée sur la couche active 3 et elle pénètre à travers les zones non continues 30 de cette couche active. La solution de gravure peut être apportée sur toute la surface de la couche active ou de manière localisée. On peut mettre en oeuvre un dépôt localisé dans le cas où plusieurs dispositifs différents sont sur la même matrice, certains d'entre eux étant sensibles à la solution de gravure.

La solution de gravure atteint alors la couche conductrice 2 à travers les zones 30, ce qui permet d'éliminer localement la couche 2, dans les zones identifiées 20 sur la figure 2.

Ces zones 20 sont donc dépourvues de tout matériau.

Pour favoriser la gravure de la zone 2, il est préférable que la solution de gravure pénètre rapidement à travers les zones 30.

La vitesse de pénétration de la solution de gravure peut être augmentée en utilisant un milieu réactionnel chaud, c'est-à-dire un milieu dont la température est comprise entre 25°C et 200°C. De préférence, la température est comprise entre 30 et 60°C.

De même, afin d'aider au mouillage, des éléments mouillants du type tensioactifs, peuvent être utilisés. Ces éléments sont alors ajoutés à la solution de gravure.

La vitesse de pénétration de la solution de gravure peut également être accrue grâce à des traitements augmentant la tension de surface de la couche active 3. Il peut notamment s'agir de traitements oxygénés de type plasma (02, SF6, N2, mélanges), UV-O3, UV-free, plasmas atmosphériques ou encore de traitements en voie liquide (du type trempage dans solvants ou dans des solutions à base de molécules polaires).

La durée de la gravure dépend de la température et de la pression, des matériaux constitutifs de l'empilement ainsi que de la solution de gravure.

Les semi-conducteurs organiques de la couche active peuvent être dopés par la présence d'ions positifs ou négatifs. Ce dopage est de nature réversible. Ces ions peuvent être de nature identique à ceux présents dans les solutions de gravure utilisées pour l'invention. Cependant, dans le procédé, aucun signe de dopage non intentionnel de la couche active n'a été constaté.

De façon générale, la durée de la gravure sera choisie de telle sorte que la surface de la zone 20 gravée dans la couche 2, à travers un défaut 30 de la couche active 3, soit au moins égale à la surface de ce défaut. Les surfaces sont ici comprises dans le plan des couches 2 et 3.

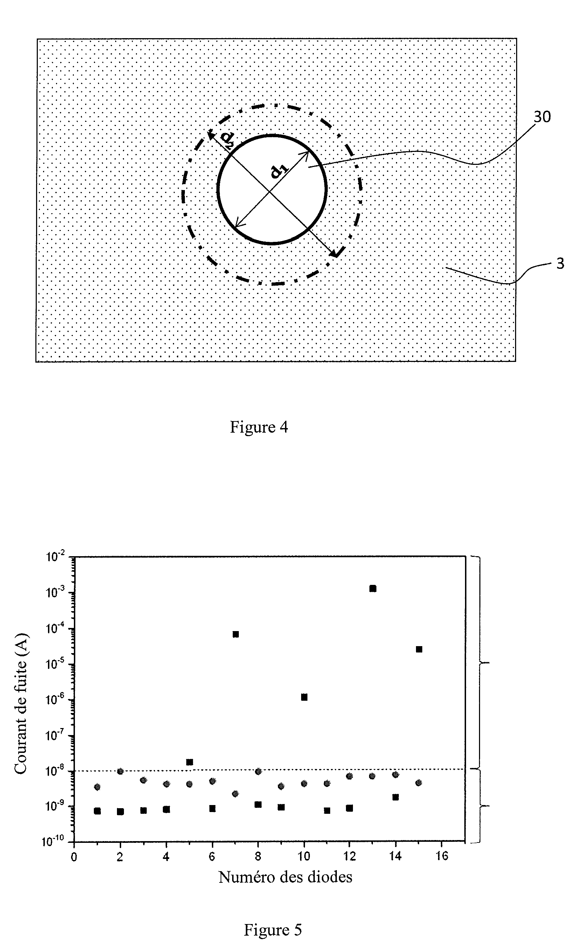

Ceci est illustré par la figure 4 qui montre, vue de dessus, la couche 3, au niveau d'un défaut 30. Il s'agit ici d'un trou micrométrique dont l'entrée est schématiquement représentée par un disque. Ce dernier présente un diamètre d₁.

Par ailleurs, la figure 4 montre, délimitée par un trait pointillé, la zone 20 de la couche 2 qui a été gravée et qui est donc dépourvue de tout matériau et, en particulier, de matériau conducteur. Cette zone 20 est schématiquement représentée sous la forme d'un disque de diamètre d₂ qui est supérieur à d₁.

Ainsi, dans le cas d'un trou, d₂ est au moins égal à d₁ et il sera de préférence égal à au moins 1,5 d₁.

Bien entendu, la zone non continue 30 peut présenter une forme différente de celle d'un disque. Il peut notamment s'agir d'une fissure allongée.

Dans tous les cas, la zone 20 présente au moins les dimensions du défaut et de préférence, une dimension au moins 1,5 fois plus importante.

Il convient encore de noter que, lorsque la couche 2 se présente sous la forme d'un empilement de plusieurs couches de matériaux différents, des solutions de gravure différentes pourront également être utilisées successivement, de façon à pouvoir graver complètement l'ensemble de la couche 2.

Ce sera également le cas si une couche d'interface a été déposée entre les couches 2 et 3.

Dans une variante, la couche active 3 n'est pas déposée de façon continue sur la couche 2 mais de façon localisée, en motifs. Ceci permet d'obtenir un gain en performance et de réduire la consommation de matériau actif. Ce dépôt localisé peut être obtenu par une technique d'impression ou bien par une méthode soustractive de lithographie.

L'attaque de la couche 2 se fait toujours à travers les défauts de la couche 3.

Dans une autre variante de réalisation, une couche de matériau diélectrique est déposée localement entre la couche 2 et la couche active 3 ou sur la couche active 3. Cette couche diélectrique permet de protéger les zones de la couche 2 que l'on ne souhaite pas exposer à la solution de gravure.

Cette couche de matériau diélectrique se présente sous la forme d'une couche localisée, obtenue par une technique d'impression, ou par photolithographie.

Lorsque cette couche est présente entre les couches 2 et 3, elle peut être constituée en une résine de photolithographie, comme la résine d'insolation S1818 ou SU8 par exemple.

Elle peut également être réalisée en polyéthylène, polypropylène, cyclooléfine, ou en un polymère réticulable.

Lorsqu'elle est déposée sur la couche active, elle doit pouvoir être déposée dans un solvant orthogonal à la couche active et elle ne doit pas se dissoudre dans la solution de gravure qui sera apportée sur la couche active.

Elle peut alors être notamment constituée de matériaux de type polymères fluorés, notamment PTFE, CYTOP, Halfon, Teflon ou résine ortho360 de la société Orthogonalinc.

Les matériaux suivants peuvent être utilisés entre les couches 2 et 3 et sur la couche 3 : polyvinylphénol, polyvinylpyrrolidone, polyvinylalcool ou polymère fluoré.

Cette couche permet de définir les zones où la couche 2 sera attaquée par la solution de gravure. En effet, il convient de noter que, lors de l'apport localisé de la solution de gravure, il peut exister des contaminations non désirées dans certaines zones. Cette contamination n'existe pas si ces zones sont protégées par un matériau diélectrique.

Une fois la gravure terminée, l'empilement illustré à la figure 2 sera rincé, de façon à stopper la réaction de gravure et à éliminer d'éventuelles traces résiduelles de solution de gravure dans la couche active 3.

Cette étape de rinçage sera réalisée par trempage dans au moins un bain d'eau désionisée, d'un solvant orthogonal ou encore d'un mélange eau/solvant orthogonal. Dans une variante, la solution de rinçage pourra être légèrement acide (si l'attaque chimique préalable est basique) et vice-versa afin de tamponner le pH de la solution lors du rinçage.

Bien entendu, le rinçage de l'empilement peut également être réalisé par projection d'un liquide approprié, en variante d'un trempage dans un bain.

Lorsque le ou les matériaux constitutifs de la couche 2 sont du type 1, 2 ou 3, l'élimination de ce(s) matériau(x) au niveau des zones 20 se fait par des mécanismes de réactions chimiques, entraînant la transformation et la dégradation du matériau conducteur dans le but de le(s) dissoudre.

Lorsque le matériau constitutif de la couche 2 est du type 4, la formation des zones 20 se fait par des mécanismes de dissolution sélective de la couche conductrice 2 par rapport à la couche active 3, les matériaux constitutifs des couches 2 et 3 étant tous du type carboné. Dans ce cas, ce n'est pas une solution de gravure à proprement parlé mais un solvant qui est utilisé. Ce solvant dissout la couche 2 sans dissoudre la couche 3.

La figure 3 illustre une dernière étape du procédé selon l'invention dans laquelle est déposée une couche 4 d'un matériau conducteur qui formera la deuxième électrode conductrice.

Cette couche 4 peut être formée par un matériau d'un des quatre types décrits précédemment, pour la couche 2.

Cette couche 4 pourra se présenter sous la forme d'une monocouche d'un de ces matériaux, d'un mélange à base de plusieurs de ces matériaux ou encore d'un empilement de couches de ces différents matériaux, seuls ou en mélange.

Elle pourra être déposée par les mêmes techniques que celles utilisées pour le dépôt de la couche 2.

Grâce à l'élimination locale, au niveau des zones 20, du matériau constitutif de la couche 2, les deux électrodes 2 et 4 ne peuvent pas être en contact, malgré l'existence des défauts 30.

Ceci permet de réduire considérablement l'apparition de courants de fuite dans la couche active 3, en supprimant les courts-circuits électriques.

Ceci permet donc de pallier les inconvénients des empilements connus dans l'état de la technique, tout en évitant à la fois une augmentation de l'épaisseur de la couche active et la mise en oeuvre de techniques de filtrage, en pratique difficiles à réaliser à l'échelle industrielle.

En variante, si cette étape de filtration est maintenue, elle peut être facilitée en utilisant des filtres à plus larges pores par exemple 1µm ou 5µm, au lieu de 0.2 ou 0.45µm. En effet, de tels filtres peuvent laisser passer davantage d'agrégats, susceptibles de créer des défauts à l'origine de courants parasites. Cependant, l'invention permettant de limiter les courants de fuite, le fonctionnement du dispositif obtenu reste amélioré.

Lorsque la couche 4 est déposée par voie liquide, c'est-à-dire sous la forme d'un matériau dans un solvant, il convient d'éviter que le matériau constitutif de la couche 4 ne vienne en contact avec les matériaux constitutifs de la couche 2, en passant à travers les défauts 30.

Ceci peut être obtenu en donnant au matériau déposé sur la couche 3 une viscosité élevée. Dans ce cas, la couche 4 sera solidifiée du fait de l'évaporation du solvant, avant que le matériau déposé n'ait le temps de diffuser à travers les défauts de la couche active.

Si le matériau utilisé présente une viscosité faible, il conviendra de réaliser, lors de l'étape de gravure, des zones 20 de dimensions suffisamment importantes pour que le matériau constitutif de la couche 4 soit solidifié avant d'avoir atteint le matériau constitutif de la couche 2.

Plusieurs exemples de mise en oeuvre du procédé selon l'invention vont maintenant être décrits.

Dans tous les exemples, le procédé est mis en oeuvre pour réaliser des photodiodes organiques sur un substrat rigide en verre ou un substrat flexible en matière plastique, par exemple du type PET ou PEN.

Par ailleurs, dans tous les exemples, la couche active est du type hétérojonction volumique. Elle est déposée sur toute la surface de la couche 2 par spin-coating, ou d'autres techniques d'impression du type slot die, docteur-blade, sérigraphie, héliogravure, jet d'encre ou spray.

Cette couche active 3 est un mélange d'un matériau donneur d'électrons avec un matériau accepteur d'électrons. Le matériau donneur peut être un polymère conjugué du type du type poly(3-hexylthiophène) ou P3HT régiorégulier ou random, le PCDTBT, le PCPDTBT ou le Si-PCPDTBT.

Par ailleurs, le matériau accepteur peut être une molécule de type fullerene (C60, C70, C80) ou un dérivé de fullerene (60PCBM, 70PCBM, 80PCBM) ou une petite molécule de la famille des acènes diimides ou un polymère conjugué du type F8BT ou N2200 commercialisé par la société Polyera.

L'épaisseur de la couche active est comprise entre 5 et 2x10⁴ nm.

De préférence, la couche active est recuite après son dépôt. Le recuit permet de figer la morphologie de la couche active et d'éliminer le solvant piégé dans la couche active. Il permet également d'améliorer l'adhésion de la couche active 3 sur la couche 2 avant l'étape de trempage dans la solution de gravure.

Dans les exemples 1 à 4, la deuxième électrode comporte une couche 4 d'encre Ag . Ce matériau peut être déposé en solution aqueuse par jet d'encre, sérigraphie, héliogravure, slot die ou spray.

De plus, une couche d'interface de PEDOT-PSS peut être utilisée entre les couches 3 et 4. Cette couche d'interface peut être de type MoO3, WO3, V2O5, Nafion, polyfluorène, poly(oxyde d'éthylène).

Dans ces quatre premiers exemples, la couche conductrice métallique peut être déposée par évaporation d'un métal du type Ag, Au ou Pt.

Dans l'exemple 5, la deuxième électrode 4 est constituée d'une couche métallique, comme celle qui est prévue dans les exemples 1 à 4.

La couche d'interface entre les couches 3 et 4 est réalisée en ZnO.

Les données spécifiques à chacun des exemples 1 à 5 sont regroupées dans le tableau ci-après.

En particulier, ce tableau indique les solutions de gravure ou solvants utilisés, ainsi que la durée de la gravure, en fonction de la nature du ou des matériaux constitutifs de la couche 2 (première électrode).

| | Exemple 1 | Exemple 2 | Exemple 3 | Exemple 4 | Exemple 5 |
|---|---|---|---|---|---|
| Première électrode (couche 2) | Oxyde conducteur transparent Monocouche AZO | Oxyde conducteur transparent Multicouches AZO/Ag/AZO ou ZnO/Ag/ZnO | Métal Au | Tapis de nanofils d'Ag | Polymère conducteur PEDOT/PSS |
| Epaisseur de la couche 2 | 50 à 500 nm | 67 nm/9 nm/42 nm | < 10 nm si couche transparente | <1µm | 50-500nm |
| Couche d'interface (entre les couches 2 et 3) | TiOx, ZnO | | | | - |
| Epaisseur de la couche d'interface | Quelques dizaines de nm | | | | - |
| Solution de gravure ou solvant | Variante 1 : A base de HCl (1-5% vol) et de FeCl₃ (25-30%) dilués dans l'eau Variante 2 : A base d'acide oxalique 0.001 mol/L dans eau DI Variante 3 : A base d'HCl dilué (0.01% vol) dans Eau DI | | A base de Kl (75g/l) et de I₂ (6,34g/l) dilués dans l'eau | A base de HNO₃ (20%vol) dilué dans l'eau | Eau désionisée |
| Température de la solution de gravure | Variante 1 : 40°- 50° C Variantes 2 : et 3 : Température ambiante | | Température ambiante | Température ambiante | Environ 50°C |
| Durée de la gravure | Variante 1 : 30 s Variantes 2 et 3 : 10nm/min | | 15 s | | 5 mn |
| Rinçage après gravure | Eau désionisée | | | | - |
| Séchage après rinçage | 100°C/2min | | | | |
| Couche d'interface (entre les couches 3 et 4) | PEDOT-PSS | | | | ZnO |
| Deuxième électrode (couche 4) | Métallique | | | | |

Il est fait maintenant référence à la figure 5 qui donne la valeur du courant de fuite pour une pluralité de diodes. En abscisses, figure le numéro d'identification des diodes et en ordonnées, le courant dans l'obscurité, mesuré à une polarisation de -1 V, correspondant à un régime bloqué de la diode.

Ces diodes sont obtenues à partir d'un empilement du type de l'exemple 1 qui comporte :
- une première électrode 2 en AZO d'une épaisseur de 125 nm,
- une couche d'interface en ZnO, d'une épaisseur de 40 nm,
- une couche active 3 en un mélange de P3HT et de 60 PCBM, présentant une épaisseur de 300 nm, et
- une deuxième électrode 4 en PEDOT/PSS d'une épaisseur de 200 nm, recouverte d'une couche d'Ag d'une épaisseur de 8 µm.

Certaines diodes (■), dites diodes standard, ne subissent aucun traitement particulier.

D'autres diodes (●) sont réalisées conformément au procédé selon l'invention, une étape d'attaque chimique étant effectuée après le dépôt de la couche active et avant le dépôt de la deuxième électrode.

Cette étape est réalisée conformément à la variante 1 de l'exemple 1, au moyen de la solution de gravure dont le nom commercial est TE100, pendant une durée de 30 s.

L'empilement des trois couches (première électrode, couche d'interface et couche active) est rincé avec de l'eau désionisée, puis séché pendant 2 mn à 100°C.

La figure 5 montre qu'une partie des diodes standard (■) correspond à un courant de fuite aléatoire pour certaines diodes et supérieur à 10⁻⁸ A. En effet, certaines diodes standard présentent un faible courant de fuite.

Par contre, toutes les diodes selon l'invention (●) correspondent à un courant de fuite inférieur à 10⁻⁸A.

Il ressort donc que le procédé selon l'invention permet de réduire les courants de fuite parasites dans les diodes et donc d'éliminer le risque d'apparition de courants de fuite qui existe avec des diodes standard.

Il convient encore de noter que, dans les exemples 3 et 4, la présence d'une couche d'interface en ZnO nécessite de prévoir une deuxième étape de gravure. Elle mettra en oeuvre la solution de gravure de la variante 1 des exemples 1 et 2 (dont le nom commercial est TE100), cette solution étant commercialisée par Transene company, à une température comprise entre 40 et 50°C et pendant une durée de 10 s.

Par contre, avec les exemples 1 et 2, la même solution de gravure servira à réaliser l'étape (c) du procédé et la gravure de la couche d'interface.

Dans une variante des exemples 1 et 2, la solution de gravure peut être remplacée par une pâte sérigraphiable du type Isishape HiperEtch 9S (commercialisée par la société Merck) ou du type ITO126-1 (commercialisée par la société Transene).

Cette pâte est déposée localement par sérigraphie, de façon à éviter la détérioration de certains dispositifs. Elle est ensuite chauffée à une température d'environ 100° pour attaquer la couche conductrice 2.

La durée de l'étape de gravure est fonction de l'épaisseur de la couche 2.

Les signes de référence insérés après les caractéristiques techniques figurant dans les revendications ont pour seul but de faciliter la compréhension de ces dernières et ne sauraient en limiter la portée.

## Revendications

1. Procédé de réalisation d'un empilement du type première électrode/couche active/deuxième électrode, destiné à un dispositif électronique, notamment du type photodétecteur organique ou cellule solaire organique, comportant les étapes suivantes :
(a) dépôt d'une première couche (2) de matériau conducteur sur un substrat (1), pour former la première électrode,
(b) dépôt d'une couche active (3), sous la forme d'une couche mince semi-conductrice organique, cette couche comportant des zones (30) non continues,
(c) élimination locale par attaque chimique de la première couche conductrice (2), à travers les zones non continues (30) de la couche active (3) pour produire des zones dépourvues de tout matériau dans ladite première couche (2), les zones dépourvues ayant au moins des dimensions latérales des zones non continues de la couche active, et
(d) dépôt d'une deuxième couche (4) de matériau conducteur sur la couche active (3), pour former la deuxième électrode conductrice.

2. Procédé selon la revendication 1, dans lequel la première couche (2) est réalisée en au moins un matériau pris parmi un oxyde conducteur transparent, un métal et un matériau carboné.

3. Procédé selon la revendication 2, dans lequel le matériau métallique se présente sous la forme d'une couche continue ou d'un réseau de nanofils métalliques.

4. Procédé selon l'une des revendications 1 à 3, dans lequel l'étape (c) est réalisée au moyen d'une solution de gravure ou d'un solvant.

5. Procédé selon la revendication 4, dans lequel la solution de gravure ou le solvant sont appliqués sur l'ensemble de la couche active (3).

6. Procédé selon la revendication 4, dans lequel la solution de gravure ou le solvant sont appliqués localement sur la couche active (3).

7. Procédé selon l'une des revendications 1 à 6, dans lequel la couche active est déposée sous la forme d'une couche continue ou de façon localisée.

8. Procédé selon l'une des revendications 1 à 7, dans lequel une couche d'interface est déposée entre la première couche (2) de matériau conducteur et la couche active (3) et/ou entre la couche active (3) et la deuxième couche (4) du matériau conducteur.

9. Procédé selon l'une des revendications 1 à 8, dans lequel une couche de matériau diélectrique est déposée entre la première couche de matériau conducteur (2) et la couche active (3).

10. Empilement du type première électrode/couche active/deuxième électrode, destiné à un dispositif électronique et comprenant successivement :
- une première couche (2) de matériau conducteur formant la première électrode et comportant des zones (20) dépourvues de tout matériau,
- une couche active (3), sous la forme d'une couche mince semi-conductrice organique, cette couche comportant des zones (30) non continues, et
- une deuxième couche (4) de matériau conducteur, formant la deuxième électrode conductrice, les zones dépourvues (20) de tout matériau étant situées au-dessous des zones (30) non continues de la couche active (3) et les zones (20) dépourvues de tout matériau ayant au moins des dimensions latérales des zones (30) non continues.

## Patentansprüche

1. Verfahren zur Herstellung eines Stapels aus einer ersten Elektrode/einer aktiven Schicht/einer zweiten Elektrode, der für eine elektronische Vorrichtung, insbesondere vom Typ organischer Photodetektor oder organische Solarzelle, bestimmt ist, das die folgenden Schritte umfasst:
(a) Aufbringen einer ersten Schicht (2) aus leitfähigem Material auf einem Substrat (1), um die erste Elektrode zu bilden,
(b) Aufbringen einer aktiven Schicht (3) in der Form einer organischen Halbleiter-Dünnschicht, wobei diese Schicht nicht ununterbrochene Zonen (30) umfasst,
(c) lokale Beseitigung der ersten leitfähigen Schicht (2) durch Ätzen durch die nicht ununterbrochenen Zonen (30) der aktiven Schicht (3), um Zonen zu erzeugen, die frei von jeglichem Material in der ersten Schicht (2) sind, wobei die freien Zonen mindestens seitliche Abmessungen der nicht ununterbrochenen Zonen der aktiven Schicht aufweisen, und
(d) Aufbringen einer zweiten Schicht (4) aus leitfähigem Material auf der aktiven Schicht (3), um die zweite leitfähige Elektrode zu bilden.

2. Verfahren nach Anspruch 1, wobei die erste Schicht (2) aus mindestens einem Material hergestellt ist, das unter einem transparenten leitfähigen Oxid, einem Metall und einem kohlenstoffhaltigen Material gewählt wird.

3. Verfahren nach Anspruch 2, wobei das metallische Material die Form einer ununterbrochenen Schicht oder eines Netzes aus metallischen Nanodrähten aufweist.

4. Verfahren nach einem der Ansprüche 1 bis 3, wobei der Schritt (c) mittels einer Ätzlösung oder eines Lösungsmittels ausgeführt wird.

5. Verfahren nach Anspruch 4, wobei die Ätzlösung oder das Lösungsmittel auf die gesamte aktive Schicht (3) aufgebracht werden.

6. Verfahren nach Anspruch 4, wobei die Ätzlösung oder das Lösungsmittel lokal auf die aktive Schicht (3) aufgebracht werden.

7. Verfahren nach einem der Ansprüche 1 bis 6, wobei die aktive Schicht in der Form einer ununterbrochenen Schicht oder auf lokalisierte Art und Weise aufgebracht wird.

8. Verfahren nach einem der Ansprüche 1 bis 7, wobei eine Grenzflächenschicht zwischen der ersten Schicht (2) aus leitfähigem Material und der aktiven Schicht (3) und/oder zwischen der aktiven Schicht (3) und der zweiten Schicht (4) aus leitfähigem Material aufgebracht wird.

9. Verfahren nach einem der Ansprüche 1 bis 8, wobei eine Schicht aus dielektrischem Material zwischen der ersten Schicht aus leitfähigem Material (2) und der aktiven Schicht (3) aufgebracht wird.

10. Stapel aus einer ersten Elektrode/einer aktiven Schicht/einer zweiten Elektrode, der für eine elektronische Vorrichtung bestimmt ist und aufeinanderfolgend Folgendes umfasst:
- eine erste Schicht (2) aus leitfähigem Material, die die erste Elektrode bildet und Zonen (20) umfasst, die frei von jeglichem Material sind,
- eine aktive Schicht (3) in der Form einer organischen Halbleiter-Dünnschicht, wobei diese Schicht nicht ununterbrochene Zonen (30) umfasst, und
- eine zweite Schicht (4) aus leitfähigem Material, die die zweite leitfähige Elektrode bildet, wobei die Zonen (20), die frei von jeglichem Material sind, sich unterhalb der nicht ununterbrochenen Zonen (30) der aktiven Schicht (3) befinden und die Zonen (20), die frei von jeglichem Material sind, mindestens seitliche Abmessungen der nicht ununterbrochenen Zonen (30) aufweisen.

## Claims

1. A method of making a stack of the type comprising a first electrode, an active layer, and a second electrode, for use in an electronic device, in particular of the organic photodetector type or the organic solar cell type, the method comprising the following steps:
a) depositing a first layer (2) of conductive material on a substrate (1) in order to form the first electrode;
b) depositing an active layer (3) in the form of a thin organic semiconductor layer, this layer including non-continuous zones (30);
c) locally eliminating the first conductive layer (2) through the non-continuous zones (30) of the active layer (3) by chemical attack, in order to form zones having no material in said first layer (2), said zones having no material having at least lateral dimensions of the non-continuous zones of the active layer, and
d) depositing a second layer (4) of conductive material on the active layer (3) in order to form the second conductive electrode.

2. A method according to claim 1, wherein the first layer (2) is made of at least one material selected from a transparent conductive oxide, a metal, and a carbon-containing material.

3. A method according to claim 2, wherein the metal material is in the form of a continuous layer or of an array of metal nanowires.

4. A method according to any one of claims 1 to 3, wherein step c) is performed by means of an etching solution or by means of a solvent.

5. A method according to claim 4, wherein the etching solution or the solvent is applied to the entire active layer (3).

6. A method according to claim 4, wherein the etching solution or the solvent is applied to the active layer (3) locally.

7. A method according to any one of claims 1 to 6, wherein the active layer is deposited in the form of a continuous layer or in localized manner.

8. A method according to any one of claims 1 to 7, wherein an interface layer is deposited between the first layer (2) of conductive material and the active layer (3), and/or between the active layer (3) and the second layer (4) of conductive material.

9. A method according to any one of claims 1 to 8, wherein a layer of dielectric material is deposited between the first layer of conductive material (2) and the active layer (3).

10. A stack of the type comprising a first electrode, an active layer, and a second electrode, for use in an electronic device and comprising in succession:
· a first layer (2) of conductive material forming the first electrode and including zones (20) having no material;
· an active layer (3) in the form of a thin organic semiconductor layer, this layer including non-continuous zones (30); and
· a second layer (4) of conductive material, forming the second conductive electrode, the zones (20) having no material being located below the non-continuous zones (30) of the active layer (3), and the zones (20) having no material having at least lateral dimensions of the non-continuous zones.
